(19) Europäisches Patentamt
European Patent Office
Office européen des brevets

(11) **EP 4 667 614 A1**

(12) **EUROPÄISCHE PATENTANMELDUNG**

(43) Veröffentlichungstag:
**24.12.2025 Patentblatt 2025/52**

(21) Anmeldenummer: **24183794.7**

(22) Anmeldetag: **21.06.2024**

(51) Internationale Patentklassifikation (IPC):
***C23C 14/04*** (2006.01)  ***C23C 14/18*** (2006.01)
***C23C 14/32*** (2006.01)  ***C23C 14/34*** (2006.01)
***C23C 14/56*** (2006.01)

(52) Gemeinsame Patentklassifikation (CPC):
**C23C 14/046; C23C 14/18; C23C 14/185;
C23C 14/32; C23C 14/3428; C23C 14/345;
C23C 14/562; C25B 11/032; H01M 8/0234**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(71) Anmelder: **voestalpine Stahl GmbH**
**4020 Linz (AT)**

(72) Erfinder:
• **Burgstaller, Wolfgang**
**4030 Linz (AT)**
• **Kapellner, Arnold**
**4030 Linz (AT)**
• **Pentschev, Peter**
**4209 Engerwitzdorf (AT)**
• **Vanden Brande, Pierre**
**6377 Seelisberg (CH)**

(74) Vertreter: **Bratovic, Nino Maria**
**Bratovic IP**
**Lissi-Kaeser-Straße 20**
**80797 München (DE)**

(54) **VERFAHREN UND VORRICHTUNG ZUM DREIDIMENSIONALEN BESCHICHTEN EINES PORÖSEN MATERIALS**

(57) Die Erfindung schafft eine Vorrichtung und ein Verfahren zum Vorrichtung (100) zum mindestens teilweisen 3-dimensionalen Beschichten eines porösen Materials (1). Die Vorrichtung (100) umfasst:
eine Beschichtungskammer (110);
eine Führungseinrichtung (120), welche dazu eingerichtet ist, ein poröses zu beschichtendes Materials (1) fortlaufend durch die Beschichtungskammer zu führen; und eine Beschichtungseinrichtung (130), welche dazu eingerichtet ist, jeweils einen aktuell in der Beschichtungskammer (110) befindlichen Teil des zu beschichtenden Materials (1) mittels physikalischer Gasphasenabscheidung in einem Vakuum (3) mit einem Beschichtungsmaterial (2) zu beschichten, welches zumindest beim Beschichten strömungsmechanische Eigenschaften im Knudsen-Bereich aufweist.

Fig. 1

**Beschreibung**

Technisches Gebiet

Die vorliegende Erfindung betrifft ein Verfahren zum sowie eine Vorrichtung zum - zumindest teilweisen - dreidimensionalen Beschichten eines porösen Materials, insbesondere eines Gewebes, eines Geleges, eines Gewirkes, eines Gestricks, eines Geflechts, eines Vlieses, eines Filzes, eines Gitters, eines Netzes, einer Nanostruktur und/oder einer dauerhaften Schaumstruktur wie etwa eines Metallschaums.

Technischer Hintergrund

Im Stand der Technik existieren bereits verschiedene Techniken zur Beschichtung von 3-dimensionalen (3D-) Strukturen, beispielsweise die Technik der physikalischen Gasphasenabscheidung (engl. "physical vapor deposition", PVD). Dabei wird ein Beschichtungsmaterial in eine gasförmige Phase gebracht und zu einem zu beschichtenden Material geführt, auf welchem es durch Resublimation abgeschieden wird. Klassische PVD-Verfahren funktionieren auf Sichtlinienbasis, d.h., nur Bereiche, die von der Quelle des Beschichtungsmaterials in einer direkten Linie erreichbar sind, können auch beschichtet werden.

Eine physikalische Gasphasenabscheidung auf perforierte Metallbänder ist beispielsweise in WO 2023/152305 A1 beschrieben. Bei verhältnismäßig dünnen Blechen mit verhältnismäßig großen Perforationen, beispielsweise Blechdicken von 0,9mm und Lochradien von 2,5 mm, ist das dort beschriebene Verfahren sehr effizient einsetzbar.

Es bestehen jedoch noch Herausforderungen bei der Abscheidung auf Materialien mit komplexen internen Strukturen (wie Gewebe oder Gelege) mit einer Vielzahl von Hinterschnitten.

Zusammenfassung der Erfindung

Nach dem oben Gesagten besteht somit ein Bedarf nach einem verbesserten Verfahren, und einer verbesserten Vorrichtung, zum Beschichten porösen Materials.

Eine Lösung wird durch die Merkmale der unabhängigen Patentansprüche bereitgestellt.

Gemäß einem ersten Aspekt stellt die Erfindung ein Verfahren zum mindestens teilweisen dreidimensionalen Beschichten eines porösen Materials bereit, umfassend zumindest die Schritte:
fortlaufendes Führen eines zu beschichtenden porösen Materials durch eine Beschichtungskammer; und fortlaufendes Beschichten jeweils eines aktuell in der Beschichtungskammer befindlichen Teils des zu beschichtenden porösen Materials mittels physikalischer Gasphasenabscheidung in einem Vakuum mit einem Beschichtungsmaterial, welches zumindest beim Beschichten mit strömungsmechanische Eigenschaften im Knudsen-Bereich aufweist.

Die Erfinder haben festgestellt, dass sich durch einerseits eine Vielzahl von verschiedenen porösen Materialien, und andererseits eine Vielzahl von Beschichtungsmaterialien mit jeweils interessanten Eigenschaften eine große Anzahl von vielversprechenden Kombinationen für alle möglichen Anwendungsbereiche ergibt, beispielsweise in der Katalysatortechnik oder für Gasdiffusionselektroden. Mit der vorliegenden Erfindung wird ein Verfahren bereitgestellt, eine Vielzahl von solchen Kombinationen, die bislang nicht oder nicht effizient herstellbar waren, zu erzeugen, und zwar nicht nur im Labor, sondern im industriellen Maßstab.

Eine grundlegende Idee der vorliegenden Offenbarung basiert auf der Erkenntnis, dass ein Beschichtungsmaterial, welches sich im Knudsen-Bereich befindet, also strömungsmechanische Eigenschaften im Knudsen-Bereich aufweist, sehr gut dafür geeignet ist, in die Zwischenräume des porösen, zu beschichtenden Materials einzudringend und dort auch Hinterschnitte effektiv zu beschichten.

Unter einem zumindest teilweisen drei-dimensionalen Beschichten soll verstanden werden, dass das 3-dimensionale Beschichten zumindest teilweise erfolgt, d.h., dass nicht jeder von außen zugängliche Abschnitt des zu beschichtenden porösen Materials beschichtet werden muss. Es kann jedoch in manchen Varianten das Beschichten auch vollständig erfolgen.

Ein fortlaufendes Führen und fortlaufendes Beschichten kann derart verstanden werden, dass ein zu Stück des zu beschichtenden porösen Materials nach dem anderen in die Beschichtungskammer eingeführt, dort beschichtet, und dann wieder aus der Beschichtungskammer entfernt wird, sodass immer nur ein Stück gleichzeitig in der Beschichtungskammer vorhanden ist und beschichtet wird (so genanntes "stückweises fortlaufendes Beschichten"), wobei das Stück beim Beschichten beispielsweise vollständig innerhalb der Beschichtungskammer angeordnet sein kann.

Das zu beschichtende poröse Material kann somit als stückige Ware vorliegen, sodass wiederholt eine Endkante eines ersten Stücks des zu beschichtenden porösen Materials die Beschichtungskammer verlässt und (gleichzeitig, vorher, oder nachher) eine Vorderkante eines zweiten Stücks des zu beschichtenden porösen Materials in die Beschichtungskammer eintritt.

Bevorzugt soll das fortlaufende Führen und fortlaufende Beschichten jedoch so verstanden werden, dass nach und nach verschiedene Abschnitte des (zusammenhängenden) zu beschichtenden porösen Materials in die Beschichtungskammer eingeführt, beschichtet, und wieder entnommen werden, wobei es vorkommen kann, dass ein erster Teil (oder: Abschnitt) des zu beschichtenden porösen Materials die Beschichtungskammer verlässt, während gleichzeitig ein zweiter Teil (oder: Abschnitt) des zu beschichtenden porösen Materials gerade beschichtet wird, während wiederum gleichzeitig ein dritter Teil (oder: Abschnitt) des zu beschichtenden porösen Materials in die Beschichtungskammer eingeführt wird (so genanntes "abschnittsweises fortlaufendes Beschichten").

Das abschnittsweise fortlaufende Beschichten ist beispielsweise vorteilhaft im Falle eines textilen Flächengebildes und/oder einer Haspelware als zu beschichtendes poröses Material, da diese häufig mit einer langgestreckten Form vorliegen und das genannte fortlaufende abschnittsweise Beschichten mit einer Vorrichtung durchgeführt werden kann, deren Abmessungen kleiner sind als die Gesamtlänge des zu beschichtenden porösen Materials.

Das zu beschichtende poröse Material kann beispielsweise auch als "Endlosband" vorliegen, d.h., dass vorne fortlaufend weiteres zu beschichtendes poröses Material angefügt (angeschweißt, angeheftet, etc.) wird und hinten fortlaufend beschichtetes poröses Material abgenommen wird, während ein dazwischen eine fortlaufende Beschichtung eines jeweils anderen Abschnitts des Endlosbands erfolgt.

Unter einem Material im Knudsen-Bereich ist insbesondere zu verstehen, dass die Knudsen-Zahl Kn für das Material kleiner gleich 10 ist, insbesondere größer gleich 0,01 und kleiner gleich 10, also

$$0{,}01 \leq Kn \leq 10.$$

Besonders bevorzugt kann die Knudsen-Zahl Kn für das Material im Bereich 0,05 bis 0,5 liegen.

Die Knudsen-Zahl Kn ist dabei definiert durch

$$Kn = \lambda / l,$$

wobei $\lambda$ die mittlere freie Weglänge des Beschichtungsmaterials und $l$ die charakteristische Länge des Strömungsfeldes des Beschichtungsmaterials in der Beschichtungskammer, insbesondere in dem Bereich der Beschichtungskammer, in welchem die Beschichtung stattfindet, darstellen. Mit anderen Worten erfolgt das Beschichten des zu beschichtenden porösen Materials vorteilhaft in einem Vakuum mit einem Beschichtungsmaterial in Knudsenströmung.

Die physikalische Gasphasenabscheidung erfolgt vorteilhaft durch einen Plasmaverdampfer, etwa wie in WO 2023/152305 A1 beschrieben. Bevorzugt erfolgt die physikalische Gasphasenabscheidung mit einer Abscheidungsrate von 0,1 $\mu$m/s ("Mikrometer pro Sekunde") oder höher, beispielsweise mit einer Abscheidungsrate im Bereich von 0,2 $\mu$m/s bis 2 $\mu$m/s.

Der Begriff "poröses Material" wird hierin als ein Oberbegriff verwendet für Materialien, in welche in irgendeiner Art und Weise Fluide (d.h. Flüssigkeiten oder Gase) eindringen können, insbesondere in makroskopischer Weise, sodass innenliegende Bereiche des porösen Materials von solchen Fluiden berührt oder benetzt werden können, und das poröse Material insbesondere auf diese Weise durchlässig für Fluide ist. Im Folgenden werden zahlreiche Beispiele für solche Materialien genannt werden, zu denen neben typischen porösen Materialien wie z.B. verschiedenen porösen Keramiken (z.B. Schaumkeramiken, direkt geschäumte Keramiken, oder Kornkeramiken) auch (insbesondere textile) Flächengebilde (wie z.B. ein Gewebe, ein Gelege, ein Gewirke, ein Gestrick, ein Geflecht, ein Vlies, ein Filz oder dergleichen) sowie Gitter, Netze, oder Nanomaterialien gehören können. Das poröse Material kann miteinander verbundene Poren, d.h., eine verbundene Porosität (engl. "interconnected porosity") aufweisen.

Das poröse Material ist insbesondere ein Material mit einer Vielzahl von Hinterschnitten. Bei solchen Materialien kommen die Vorteile der vorliegenden Lehre besonders stark zur Geltung.

Gemäß einigen bevorzugten Ausführungsformen, Varianten oder Verfeinerungen von Ausführungsformen umfasst das poröse zu beschichtende Material demnach ein Gewebe, ein Gelege, ein Gewirke, ein Gestrick, ein Geflecht, ein Vlies, einen Filz (z.B. einen Kohlenstofffilz), und/oder eine dauerhafte Schaumstruktur (z.B. einen Metallschaum oder eine Schaumkeramik).

Gemäß einigen bevorzugten Ausführungsformen, Varianten oder Verfeinerungen von Ausführungsformen umfasst das Beschichtungsmaterial ein metallisches Material (z.B. ein elementares Metall) oder besteht aus einem metallischen Material. Das Beschichtungsmaterial kann eine Legierung mehrerer Metalle umfassen oder daraus bestehen, oder ein Material aufweisen, dessen Hauptbestandteil ein Metall ist.

Als metallische Materialien kommen insbesondere Kupfer, Nickel, Mangan, oder Silber in Frage, sowie entsprechende Legierungen oder Gemische, deren Hauptbestandteil aus einem oder mehreren dieser Metalle besteht.

Als Beschichtungsmaterialien, insbesondere für Katalysatoren, kommen auch Platin, Ruthenium, Iridium und/oder Rhenium in Frage, aber auch andere katalytisch wirkende Stoffe oder Stoffgemische.

Ein weiteres mögliches Beschichtungsmaterial, beispielsweise für Batterieelektroden (etwa in einer Zink-Luft-Batterie), ist Kohlenstoff.

Gemäß einigen bevorzugten Ausführungsformen, Varianten oder Verfeinerungen von Ausführungsformen ist das Beschichtungsmaterial Silizium. Silizium ist Gegenstand beständiger Forschung und weist eine Vielzahl von vielversprechenden Eigenschaften auf.

Gemäß einigen bevorzugten Ausführungsformen, Varianten oder Verfeinerungen von Ausführungsformen weist das Beschichtungsmaterial bei seinem jeweiligen Schmelzpunkt einen Dampfdruck von $10^{-6}$ Millibar bis 10 Millibar, insbesondere von $10^{-3}$ Millibar bis 1 Millibar auf. Die Erfinder haben festgestellt, dass solche Beschichtungsmaterialien die besten Effekte erzielen.

Gemäß einigen bevorzugten Ausführungsformen, Varianten oder Verfeinerungen von Ausführungsformen weist das Beschichtungsmaterial einen Schmelzpunkt von zwischen 300°C und 1500°C auf, insbesondere von zwischen 400°C und 1200°C.

Gemäß einigen bevorzugten Ausführungsformen, Varianten oder Verfeinerungen von Ausführungsformen weist das poröse zu beschichtende Material eine Porenweite von 1 mm oder kleiner, und/oder eine spezifische Oberfläche $a_s$ nach dem BET-Verfahren von 0,1 $m^2g^{-1}$ oder größer auf.

Bei den Poren kann es sich insbesondere um Makroporen mit einer Porenweite zwischen 50 nm und 1 mm handeln, oder um Mesoporen mit einer Porenweite zwischen 2 nm und 50 nm, jeweils entsprechend bzw. angelehnt an ISO 15901:3:2007 [3], 3.10 und 3.11. Auch eine Mischung von Makroporen und Mesoporen kann vorliegen.

Die spezifische Oberfläche $a_s$ wird mit dem BET-Verfahren nach ISO 9277:2010, "Bestimmung der spezifischen Oberfläche von Festkörpern mittels Gasadsorption", bestimmt. Das poröse zu beschichtende Material weist vorteilhaft eine spezifische Oberfläche $a_s$ von 0,1 $m^2g^{-1}$ ("Quadratmeter pro Gramm") oder größer auf, insbesondere zwischen 0,1 $m^2g^{-1}$ und 100 $m^2g^{-1}$, besonders bevorzugt zwischen 0,5 $m^2g^{-1}$ und 50 $m^2g^{-1}$.

Als ein Beispiel für ein poröses zu beschichtendes Material können etwa Graphitfilze spezifische Oberflächen von zwischen 2 und 3 $m^2g^{-1}$ aufweisen, oder Karbon-Graphit-Filze spezifische Oberflächen von zwischen 0,2 $m^2g^{-1}$ und 0,8 $m^2g^{-1}$, insbesondere zwischen 0,4 $m^2g^{-1}$ und 0,6 $m^2g^{-1}$. Als ein anderes Beispiel weist Aktivkohle eine spezifische Oberfläche von 550 $m^2g^{-1}$ auf.

Gemäß einigen bevorzugten Ausführungsformen, Varianten oder Verfeinerungen von Ausführungsformen ist das poröse zu beschichtende Material eine Haspelware. Bevorzugt wird es im Verlauf des Verfahrens vor dem fortlaufenden Beschichten von einer Haspel abgewickelt und/oder nach dem fortlaufenden Beschichten auf eine Haspel aufgewickelt. Auf diese Weise kann eine große Menge des zu beschichtenden Materials nach und nach beschichtet und davor bzw. danach effizient verstaut werden. Alternativ kann das poröse zu beschichtende Material auch eine Coilware sein, und dementsprechend vor dem fortlaufenden Beschichten aus einer Coil abgewickelt und/oder nach dem fortlaufenden Beschichten wieder zu einer Coil aufgewickelt werden.

Gemäß einigen bevorzugten Ausführungsformen, Varianten oder Verfeinerungen von Ausführungsformen umfasst das Verfahren eine Wärmebehandlung des beschichteten Materials, z.B. außerhalb der Beschichtungskammer nach dem Beschichten, beispielsweise ein Anlassen eines Stahlbestandteils (z.B. um eine gewünschte Härte oder Zähigkeit zu erlangen) und/oder ein Diffusionsglühen (z.B. um Inhomogenitäten zu vermindern).

Bevorzugt erfolgt die Wärmebehandlung in einem Vakuum. Die Beschichtungskammer, in welcher ein Vakuum ausgebildet ist, kann beispielsweise auch einen Beschichtungsbereich umfassen, in welchem die Beschichtung erfolgt, und einen davon getrennten Wärmebehandlungsbereich, in welchem, immer noch im Vakuum, die Wärmebehandlung erfolgt. Im Falle von Haspelware erfolgt die Wärmebehandlung vorzugsweise vor dem Haspeln.

Gemäß einigen bevorzugten Ausführungsformen, Varianten oder Verfeinerungen von Ausführungsformen kann das zu beschichtende poröse Material für die Beschichtung negativ polarisiert werden, wobei die dadurch ausgebildete Spannung bzw. Potenzialdifferenz zu dem Beschichtungsmaterial bevorzugt zwischen 5 V und 100 V, besonders bevorzugt zwischen 30 V und 60 V, beispielsweise 50 V betragen kann.

Die Potenzialdifferenz (bzw. Spannung) relativ zum (insbesondere plasmaförmigen) Beschichtungsmaterial kann eine Geschwindigkeit von teilweise ionisierten Dampf in Richtung des zu beschichtenden Materials im Vergleich zum Fall ohne Polarisierung erhöhen, und zwar proportional zu der Spannung (bzw. Potenzialdifferenz). Hierdurch erhöht sich die kinetische Energie einzelner resublimierender (oder: kondensierender) Partikel, was wiederum eine bessere Adsorption an die Oberfläche des porösen zu beschichtenden Materials bewirken kann.

Eine Abscheidungsrate von 0,1 $\mu m/s$ oder höher, wie bevorzugt, kann dazu beitragen, etwaige Sputtering-Effekte zu verringern oder zu kompensieren.

Zudem kann der Beschuss der Oberfläche des porösen zu beschichtenden Materials mit erhöhter kinetischer Energie über thermische Effekte einen Haftungskoeffizienten an der Außenseite des zu beschichtenden Materials - im Vergleich zu dessen innenliegendem Kern - verringern. Dieser Effekt kann einer typischerweise im Kern geringeren Partikeldichte des Beschichtungsmaterials entgegenwirken (oder diese kompensieren), sodass eine Schichtdicke des Beschichtungsmaterials auf dem zu beschichtenden Material zwischen dessen Außenseite und dessen Kern gleichmäßiger erfolgt.

Das Polarisieren des zu beschichtenden porösen Materials kann beispielsweise durch eine Elektrische-Polarisationswalze erfolgen, die dazu eingerichtet ist, mit dem zu beschichtenden porösen Material in elektrischer Verbindung zu stehen. Ist das zu beschichtende poröse Material elektrisch leitfähig, kann die Elektrische-Polarisationswalze mit großer Designfreiheit angeordnet werden, vorzugsweise innerhalb des in der Beschichtungskammer ausgebildeten Vakuums.

Im Falle eines elektrisch nicht leitfähigen zu beschichtenden porösen Materials kann die Elektrische-Polarisationswalze (in Transportrichtung des zu beschichtenden porösen Materials) nach dem Beschichtungsbereich in der Beschichtungskammer angeordnet sein, derart, dass sie das Beschichtungsmaterial auf dem dann beschichteten porösen Material elektrisch kontaktiert.Ist eine Wärmebehandlung vorgesehen, kann die Elektrische-Polarisationswalze insbesondere zwischen dem Beschichtungsbereich und dem Wärmebehandlungsbereich in der Beschichtungskammer angeordnet sein.

Gemäß einigen bevorzugten Ausführungsformen, Varianten oder Verfeinerungen von Ausführungsformen werden das Führen und das Beschichten derart durchgeführt, dass das Beschichtungsmaterial (von einer Außenfläche des zu beschichtenden porösen Materials her) im Wesentlichen nur in bis zu 5 % bis 45 %, bevorzugt 10 % bis 40 %, beispielsweise 30% oder 35%, der Dicke des zu beschichtenden porösen Materials eindringt. Für viele Anwendungen ist eine vollständige interne Beschichtung des zu beschichtenden porösen Materials nicht erwünscht, oder schlicht nicht nötig.

Alternativ oder anders ausgedrückt kann vorgesehen sein, dass das Beschichtungsmaterial nur beispielsweise bis zu 20 % der Porenoberflächen, bis zu 50 % der Porenoberflächen oder bis zu 90 % der Porenoberflächen (jedoch nicht nur die Außenfläche des zu beschichtenden porösen Materials) beschichtet. Ein Teil der Poren kann dabei ausgefüllt werden.

Gemäß einigen bevorzugten Ausführungsformen, Varianten oder Verfeinerungen von Ausführungsformen erfolgt das Beschichten einseitig oder beidseitig, d.h. nur von einer einzigen Außenfläche des zu beschichtenden porösen Materials aus, oder von zwei (oder noch mehr) verschiedenen Außenflächen des zu beschichtenden porösen Materials aus, insbesondere von zwei gegenüberliegenden Außenflächen aus.

Mittels beidseitiger Beschichtung kann besonders effizient ein großes, von außen zugängliches internes Volumen des zu beschichtenden porösen Materials beschichtet werden. Werden dabei - beispielsweise - von jeder von zwei gegenüberliegenden Außenflächen aus z.B. 5%, 20%, oder 40% der Dicke des zu beschichtenden porösen Materials beschichtet, sind somit entsprechend 10%, 40%, bzw. 80% des internen Volumens des zu beschichtenden porösen Materials beschichtet.

Gemäß einigen bevorzugten Ausführungsformen, Varianten oder Verfeinerungen von Ausführungsformen wird das beschichtete poröse Material (d.h., das zu beschichtende poröse Material, nachdem es beschichtet wurde) nach Verlassen der Beschichtungskammer zumindest teilweise gepresst, insbesondere um dessen Dicke dauerhaft zu verringern und/oder dessen Dichte dauerhaft zu vergrößern. Auf diese Weise kann beispielsweise ein inelastisch kompressibles poröses Material zunächst effizienter, einfacher und/oder schneller beschichtet werden (da die Porengröße im ungepressten Zustand höher ist bzw. die internen Volumina und Hinterschnitte des porösen Materials besser zugänglich sind), und danach auf eine gewünschte niedrigere Dicke und/oder höhere Dichte gebracht werden.

Gemäß einigen bevorzugten Ausführungsformen, Varianten oder Verfeinerungen von Ausführungsformen wird das beschichtete poröse Material als eine Gasdiffusionselektrode oder als Teil einer Gasdiffusionselektrode verwendet. Eine solche Gasdiffusionselektrode wiederum kann beispielsweise in einer Brennstoffzelle (z.B. einer Wasserstoffzelle), bei einer Elektrolyse, bei der Wasserstoffperoxidproduktion, bei der Abwasserbehandlung etc. eingesetzt werden.

Für eine Gasdiffusionselektrode eignen sich beispielsweise ein Filz als poröses zu beschichtendes Material (etwa ein Kohlenstofffilz) und ein metallischer Katalysator als Beschichtungsmaterial.

Gemäß einem zweiten Aspekt stellt die vorliegende Erfindung eine Vorrichtung zum mindestens teilweisen 3-dimensionalen Beschichten eines porösen Materials bereit, umfassend:

eine Beschichtungskammer;
eine Führungseinrichtung, welche dazu eingerichtet ist, ein poröses zu beschichtendes Materials fortlaufend durch die Beschichtungskammer zu führen; und
eine Beschichtungseinrichtung, welche dazu eingerichtet ist, jeweils einen aktuell in der Beschichtungskammer befindlichen Teil des zu beschichtenden Materials mittels physikalischer Gasphasenabscheidung in einem Vakuum mit einem Beschichtungsmaterial zu beschichten, welches zumindest beim Beschichten (d.h. im Moment des Beschichtens, oder Resublimierens) strömungsmechanische Eigenschaften im Knudsen-Bereich aufweist.

Die Beschichtungseinrichtung kann eine dazu eine Vakuumquelle (insbesondere eine Vakuumpumpe), einen Plasmaverdampfer und weitere Elemente aufweisen.

Weitere vorteilhafte Ausführungsformen, Varianten, und Verfeinerungen von Ausführungsformen ergeben sich aus der nachfolgenden detaillierten Beschreibung unter Bezugnahme auf die Figuren.

Kurze Beschreibung der Figuren

Die Erfindung wird nachstehend anhand von Ausführungsbeispielen in den Figuren der Zeichnungen näher erläutert. Es zeigen hierbei:

Fig. 1    eine schematische Darstellung einer Vorrichtung gemäß einer Ausführungsform der vorliegenden Erfindung;

Fig. 2    eine schematische Darstellung einer Variante der Vorrichtung aus Fig. 1;

Fig. 3    eine schematische Darstellung einer Variante der Vorrichtung aus Fig. 2 und

Fig. 4    ein schematisches Flussdiagramm zum Erläutern eines Verfahrens gemäß einer weiteren Ausführungsform der vorliegenden Erfindung.

Die Bezeichnung und Nummerierung der Verfahrensschritte impliziert nicht zwangsläufig eine Reihenfolge, sondern dient der besseren Unterscheidung, obwohl in einigen Varianten die Reihenfolge auch der Reihenfolge der Nummerierung entsprechen kann.

Detaillierte Beschreibung der Figuren

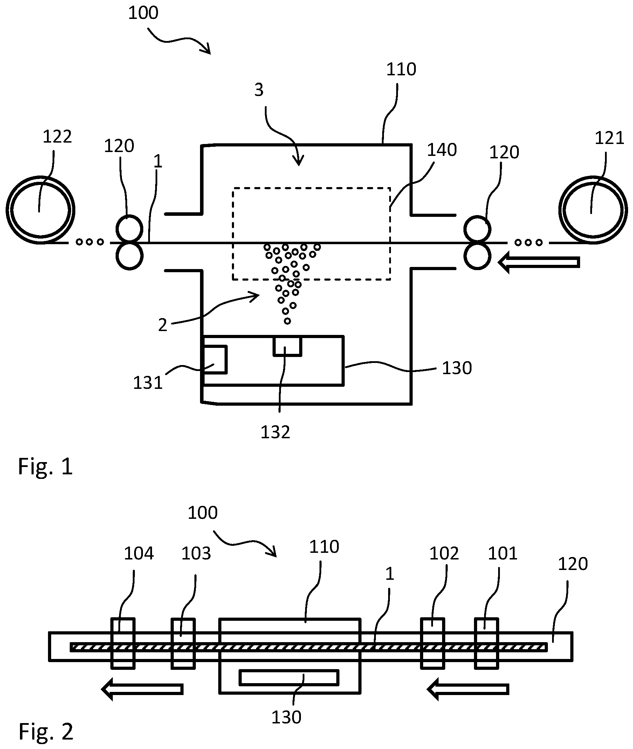

Fig. 1 zeigt eine schematische Darstellung einer Vorrichtung 100 gemäß einer Ausführungsform der vorliegenden Erfindung, d.h., eine Vorrichtung 100 zum mindestens teilweisen 3-dimensionalen Beschichten eines porösen Materials 1. Die Vorrichtung 100 umfasst eine Beschichtungskammer 110 sowie eine Führungseinrichtung 120, welche dazu eingerichtet ist, das poröse zu beschichtende Material 1 fortlaufend durch die Beschichtungskammer 110 zu führen.

Die Führungseinrichtung 120 kann in vielfältiger Weise ausgebildet sein, jeweils angepasst an die Eigenschaften des zu beschichtenden porösen Materials 1. In Fig. 1 ist die Führungseinrichtung 120 beispielsweise als mit Rollen ausgebildet dargestellt, wobei eine oder mehrere Rollen Vorschubrollen sein können, während die anderen Rollen bloße Führungsrollen sein können. Die Rollen können einseitig unter dem porösen zu beschichtenden Material 1 angeordnet sein, etwa wenn es sich um schweres und/oder steifes Material handelt, oder jeweils beidseitig angeordnet sein, wie in Fig. 1 beispielhaft gezeigt. Ist eine einseitige Beschichtung gewünscht, kann die Führungseinrichtung 120 beispielsweise auch ein Förderband umfassen, auf welchem das zu beschichtende poröse Material 1 gefördert wird.

Wie bereits erläutert wurde, kann das zu beschichtende poröse Material 1 optional eine Haspelware sein, die vor dem Beschichten von einer ersten Haspel 121 oder aus einer ersten Coil abgewickelt und/oder nach dem Beschichten auf eine zweite Haspel 22 oder zu einer zweiten Coil aufgewickelt wird, jeweils unmittelbar oder mit einem oder mehreren Zwischenschritten. Alternativ kann nach dem Beschichten auch eine Einrichtung zum Schneiden oder Teilen des beschichteten porösen Materials 1 vorgesehen sein. Die erste Haspel 121 und/oder die zweite Haspel 122, oder entsprechende Halterungen, können somit Teil der Vorrichtung 100, beispielsweise der Führungseinrichtung 120, sein.

Die Vorrichtung 100 weist außerdem eine Beschichtungseinrichtung 130 auf, welche dazu eingerichtet ist, jeweils einen aktuell in der Beschichtungskammer 110 befindlichen Teil des zu beschichtenden porösen Materials 1 mittels physikalischer Gasphasenabscheidung in einem Vakuum 3 mit einem Beschichtungsmaterial 2 zu beschichten.

Die Beschichtungseinrichtung 130 kann hierzu eine Vakuumquelle 131 (insbesondere eine Vakuumpumpe), einen Verdampfer 132 etc. umfassen, wie dies für PVD-Vorrichtungen aus dem Stand der Technik, beispielsweise aus WO 2023/152305 A1, bekannt ist. Die Lehre der WO 2023/152305 A1 wird hiermit durch Verweis in ihrer Gesamtheit in die vorliegende Offenbarung mit aufgenommen.

Erfindungsgemäß ist die Beschichtungseinrichtung 130 so eingerichtet, dass das Beschichtungsmaterial 2 beim Beschichten strömungsmechanische Eigenschaften im Knudsen-Bereich aufweist.

In der Beschichtungskammer 110 können Leiteinrichtungen 140 angeordnet sein, welche dazu angeordnet sind, das von dem Verdampfer 132 abgegebene Beschichtungsmaterial 2 innerhalb der Beschichtungskammer 110 zu leiten oder zu lenken, beispielsweise um eine homogene (einseitige oder beidseitige) Beaufschlagung des zu beschichtenden porösen Materials 1 mit dem Beschichtungsmaterial 2 zu bewirken. Die Leiteinrichtungen 140 können beispielsweise mechanische Leitbleche und/oder elektromagnetische Leiteinrichtungen umfassen.

Die Führungseinrichtung 120 kann dazu eingerichtet sein, das zu beschichtende poröse Material 1 im Wesentlichen horizontal (wie in Fig. 1 beispielhaft dargestellt), oder im Wesentlichen vertikal durch die Beschichtungskammer 110 zu führen. Insbesondere bei vertikalem Bandlauf kann der Prozess zweistufig gefahren werden, so dass das zu beschichtende poröse Material 1 zunächst in einer Richtung, zum Beispiel aufwärts, geführt wird, dann außerhalb der Beschichtungskammer 110 umgelenkt wird und anschließend abwärts wieder in die Beschichtungskammer 110 hinein geführt wird, um eine symmetrische Beschichtung des zu beschichtenden porösen Materials 1 von beiden Seiten zu erreichen.

Wie bereits erläutert wurde, können die Führungseinrichtung 120 und die Beschichtungseinrichtung 130 derart eingerichtet oder einstellbar sein, dass das Beschichtungsmaterial 2 (von einer Außenfläche des zu beschichtenden porösen Materials 1 her) im Wesentlichen nur in bis zu 5 % bis 45 %, bevorzugt 10 % bis 40 %, beispielsweise 30% oder 35%, der Dicke des zu beschichtenden porösen Materials 1 eindringt. Bei beidseitiger Beschichtung (entweder gleichzeitig oder nacheinander durch Umlenkung wie oben beschrieben) kann somit, bezogen auf das Volumen des zu beschichtenden porösen Materials 1, jeweils der doppelte Wert erzielt werden.

Es bestehen verschiedene Optionen für eine Vor- und/oder Nachbearbeitung des zu beschichtenden porösen Materials 1 bzw. des beschichteten porösen Materials 1 vor bzw. nach dem Beschichten.

Fig. 2 zeigt eine schematische Darstellung einer Variante der Vorrichtung 100 aus Fig. 1. Darin ist skizziert, wie durch die Führungseinrichtung 120 das zu beschichtende poröse Material 1 zunächst in eine (insbesondere chemische) Reinigungseinrichtung 101, dann eine Vorbehandlungseinrichtung 102 (z.B. eine Plasma-Vorbehandlungseinrichtung), und erst dann in die Beschichtungskammer 110 eingeführt wird. Außerdem ist schematisch gezeigt, dass das zu beschichtende poröse Material 1 nach dem Beschichten beispielsweise in eine Wärmebehandlungseinrichtung 103 und/oder eine Presse 104 geführt werden kann.

In der Vorbehandlungseinrichtung 102, insbesondere Plasma-Vorbehandlungseinrichtung, kann zum Beispiel eine Plasmabehandlung zum Modifizieren der Oberfläche des zu beschichtenden porösen Materials 1 durchgeführt werden, etwa Plasma-Ätzen (engl. "plasma etching"). Hierdurch kann beispielsweise eine Mikrostrukturierung der Oberfläche (z.B. zur Haftungsverbesserung) des zu beschichtenden porösen Materials 1 und/oder ein Abbau von unerwünschten Schichten (Oxidschichten, Lacken) auf/an dem zu beschichtenden porösen Material 1 erzielt werden.

Die Wärmebehandlungseinrichtung 103 kann beispielsweise zum Anlassen eines Stahlbestandteils (z.B. um eine gewünschte Härte oder Zähigkeit zu erlangen) und/oder für ein Diffusionsglühen (z.B. um Inhomogenitäten zu vermindern) eingerichtet sein.

Die Vorrichtung 100 kann eine, mehrere, oder alle der Reinigungseinrichtung 101, Vorbehandlungseinrichtung 102, Wärmebehandlungseinrichtung 103 und/oder Presse 104 aufweisen, wobei verschiedene Reihenfolgen in der Anordnung möglich sind. Wie anhand von Fig. 1 bereits dargestellt wurde, kann die Führungseinrichtung 120 das zu beschichtende poröse Material 1 aus einer ersten Haspel 121 oder einer ersten Coil entnehmen und das beschichtete poröse Material 1 in eine zweite Haspel 122 oder zu einer zweiten Coil aufwickeln.

Jede der genannten Nachbearbeitungen kann entweder abschnittsweise, oder aber nach Abschluss des Beschichtens des gesamten porösen Materials 1 erfolgen.

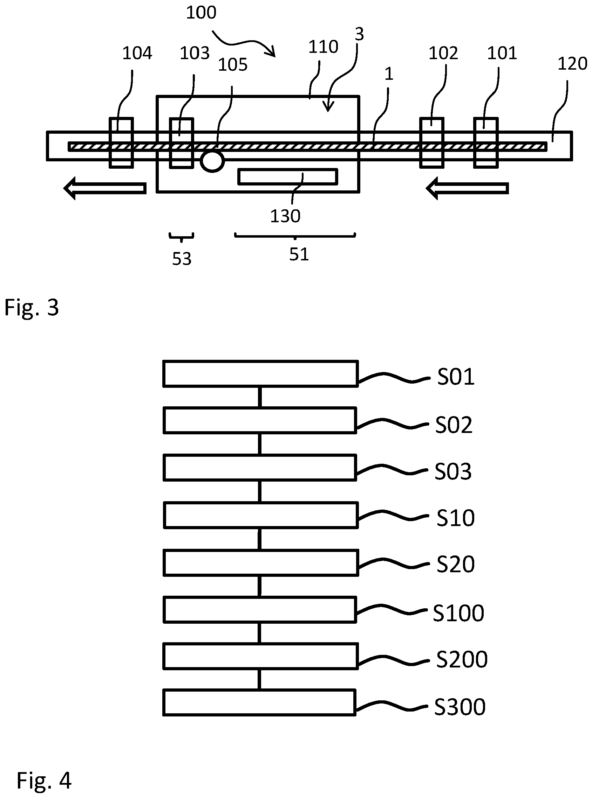

Fig. 3 zeigt eine Variante der Vorrichtung 100 aus Fig. 2, welche zusätzlich eine Elektrische-Polarisationsrolle 105 aufweist, mittels welcher das zu beschichtende poröse Material 1 im Vergleich zu dem Beschichtungsmaterial während der Beschichtung negativ polarisierbar ist. Die dadurch ausgebildete Spannung bzw. Potenzialdifferenz zu dem Beschichtungsmaterial beträgt bevorzugt zwischen 5 V und 100 V, besonders bevorzugt zwischen 30 V und 60 V, beispielsweise 50 V.

Im Falle eines elektrisch nicht leitfähigen zu beschichtenden porösen Materials 1 ist die Elektrische-Polarisationswalze 105(in Transportrichtung des zu beschichtenden porösen Materials 1) vorteilhaft nach einem Beschichtungsbereich 51 in der Beschichtungskammer 101 angeordnet, derart, dass sie das Beschichtungsmaterial 1 auf dem dann bereits beschichteten porösen Material elektrisch kontaktiert. Ist eine Wärmebehandlung vorgesehen, kann die Elektrische-Polarisationswalze 105 insbesondere zwischen einem Beschichtungsbereich 51 (an welchem die Beschichtung stattfindet) und einem Wärmebehandlungsbereich 53 (in welchem die Wärmebehandlungseinrichtung 103 auf das beschichtete poröse Material 1 wirkt) in der Beschichtungskammer 110 unter dem Vakuum 3 angeordnet sein.

Im Falle eines elektrisch leitfähigen zu beschichtenden porösen Materials kann die Elektrische-Polarisationswalze 105 an einem beliebigen Ort angeordnet sein, an welchem sie mit dem zu beschichtenden porösen Material, welches sich im Beschichtungsbereich 51 befindet, in elektrischem Kontakt steht, vorzugsweise jedoch ebenfalls in dem Vakuum 3 innerhalb der Beschichtungskammer 110.

Fig. 4 zeigt ein schematisches Flussdiagramm zum Erläutern eines Verfahrens gemäß einer Ausführungsform der vorliegenden Erfindung, d.h. eines Verfahrens zum mindestens teilweisen dreidimensionalen Beschichten eines porösen Materials 1. Das Verfahren gemäß Fig. 4 ist mittels der Vorrichtung 100 aus

Fig. 1 durchführbar, aber auch unabhängig davon. Das Verfahren kann gemäß allen in Bezug auf die erfindungsgemäße Vorrichtung 100 beschriebenen Ausführungsformen, Optionen, Varianten, und Verfeinerungen angepasst werden und umgekehrt.

Daher werden im Folgenden teilweise zur Veranschaulichung auch Bezugszeichen aus den Fig. 1 bis Fig. 3 verwendet, ohne dass dies eine zwingend notwendige Verwendung der Vorrichtung 100 implizieren soll.

In einem Schritt S10 wird das zu beschichtende poröse Material 1 fortlaufend durch eine Beschichtungskammer 110 geführt, beispielsweise wie im Vorangehenden mit Bezug auf die Führungseinrichtung 120 und die Beschichtungskammer 110 beschrieben wurde.

In einem Schritt S20 erfolgt ein fortlaufendes Beschichten jeweils eines aktuell in der Beschichtungskammer 110 befindlichen Teils des zu beschichtenden porösen Materials 1 mittels physikalischer Gasphasenabscheidung in einem Vakuum 3 mit einem Beschichtungsmaterial 2, welches zumindest beim Beschichten S20 strömungsmechanische Eigenschaften im Knudsen-Bereich aufweist, d.h., in einer Knudsenströmung vorliegt. Das Beschichten S20 kann insbesondere derart erfolgen, wie im Vorangehenden bereits mit Bezug auf die Beschichtungseinrichtung 130 beschrieben wurde. Insbesondere kann das Beschichten S20 einseitig oder beidseitig (letzteres wiederum gleichzeitig oder nacheinander), teilweise oder vollständig erfolgen.

Die physikalische Gasphasenabscheidung erfolgt vorteilhaft durch einen Plasmaverdampfer, etwa wie in WO 2023/152305 A1 beschrieben. Bevorzugt erfolgt die physikalische Gasphasenabscheidung mit einer Abscheidungsrate von 0,1 $\mu$m/s ("Mikrometer pro Sekunde") oder höher, beispielsweise mit einer Abscheidungsrate im Bereich von 0,2 $\mu$m/s bis 2 $\mu$m/s.

Bei dem zu beschichtenden porösen Material 1 kann es sich, wie im Vorangehenden ebenfalls bereits ausführlich erläutert wurde, um mindestens eines der folgenden handeln:

- eine poröse Keramik (z.B. eine Schaumkeramik, direkt geschäumte Keramik, oder Kornkeramik),
- eine dauerhafte Schaumstruktur (z.B. einen Metallschaum oder die bereits genannte Schaumkeramik),
- ein poröses (insbesondere textiles) Flächengebilde, (z.B. ein Gewebe, ein Gelege, ein Gewirke, ein Gestrick, ein Geflecht, ein Vlies, einen Filz - insbesondere einen Kohlenstofffilz),

- ein Gitter,
- ein Netz,
- ein Nanomaterial,
- und/oder dergleichen mehr.

Als Beschichtungsmaterial 2 kommt eine Vielzahl von bereits genannten Materialien und Materialkombinationen in Frage, beispielsweise Kupfer, Nickel, Mangan, Silber, Platin, Ruthenium, Iridium, Rhenium, Silizium oder Kohlenstoff.

Allgemein werden als Beschichtungsmaterial 2 insbesondere solche Materialien bevorzugt, welche bei ihrem jeweiligen Schmelzpunkt einen Dampfdruck von 1 Mikrobar bis 10 Millibar, insbesondere von 0,1 Millibar bis 5 Millibar aufweisen und/oder einen Schmelzpunkt von zwischen 300°C und 1500°C auf, insbesondere von zwischen 400°C und 1200°C aufweisen.

Vor dem eigentlichen Beschichten S20 des zu beschichtenden porösen Materials 1 in der Beschichtungskammer 110 können optionale vorangehende Schritte durchgeführt werden, die je nach dem zu beschichtenden porösen Material 1 und dem Beschichtungsmaterial 2 vorgesehen werden können.

Beispielsweise kann das zu beschichtende poröse Material 1, falls es sich um eine Haspelware oder Coilware handelt, in einem Schritt S01 von einer (ersten) Haspel 121 oder Coil abgewickelt werden.

In einem Schritt S02 kann eine chemische Vorreinigung des zu beschichtenden porösen Materials 1 durchgeführt werden, beispielsweise mit der Reinigungsvorrichtung 101.

In einem Schritt S03 kann eine vakuumbasierte Vorbehandlung mittels Plasma durchgeführt werden, beispielsweise mit der Vorbehandlungseinrichtung 102. Die vakuumbasierte Vorbehandlung kann z.B. ein Plasmaätzen umfassen.

Ebenso können verschiedene vorteilhafte Verarbeitungsschritte des dann beschichteten porösen Materials 1 auch nach dem Beschichten S20 durchgeführt werden.

Beispielsweise kann in einem Schritt S100 eine Wärmebehandlung durchgeführt werden, etwa ein Anlassen eines Stahlbestandteils (z.B. um eine gewünschte Härte oder Zähigkeit zu erlangen) und/oder ein Diffusionsglühen (z.B. um Inhomogenitäten zu vermindern). Dies kann beispielsweise in der Wärmebehandlungseinrichtung 103 der Vorrichtung 100 erfolgen.

Wie insbesondere mit Bezug auf Fig. 3 erläutert wurde, kann auch eine elektrische Potenzialdifferenz zwischen dem zu beschichtenden porösen Material 1 (oder zumindest dessen Beschichtungsmaterial nach der Beschichtung) und dem Beschichtungsmaterial während des Beschichtens erzeugt werden. Die dadurch ausgebildete Spannung oder Potenzialdifferenz zu dem Beschichtungsmaterial beträgt bevorzugt zwischen -5 V und -100 V, besonders bevorzugt zwischen -30 V und -60 V, beispielsweise -50 V.

Alternativ oder zusätzlich kann in einem Schritt S200 ein Pressen des zu beschichtenden porösen Materials 1 erfolgen, insbesondere um dessen Dicke dauerhaft zu verringern und/oder dessen Dichte dauerhaft zu vergrößern, beispielsweise mit der Presse 104 der Vorrichtung 100.

Weiterhin kann, falls es sich bei dem beschichteten porösen Material 1 um eine Haspelware oder Coilware handelt, in einem Schritt S300 ein Aufwickeln auf eine (zweite) Haspel 122 oder Coil erfolgen.

Das Verfahren kann ein Herstellen einer Gasdiffusionselektrode unter Verwendung des beschichteten porösen Materials 2 umfassen, wobei das beschichtete poröse Material 1 als die Gasdiffusionselektrode oder als Teil der Gasdiffusionselektrode verwendet wird. In diesem Fall ist das Verfahren auch als Verfahren zur Herstellung einer Gasdiffusionselektrode bezeichenbar.

Beispielsweise kann es sich bei dem zu beschichtenden porösen Material 2 um einen Kohlenstofffilz handeln, der anfänglich auf einer ersten Haspel 121 aufgewickelt ist. Nach dem Abwickeln S01 von der ersten Haspel 121 und einem chemischen Reinigen S02 wird der Kohlenstofffilz fortlaufend in die Beschichtungskammer 110 geführt S10, und dort fortlaufend beschichtet S20. Das fortlaufende Beschichten S20 kann insbesondere mit einem Katalysatormaterial erfolgen, wie etwa mit Platin, Ruthenium, Iridium und Rhenium, oder allgemein mit einem Metall oder einer Legierung, umfassend insbesondere Kupfer, Nickel, Mangan, und/oder Silber.

Nach dem Beschichten S20 kann der beschichtete Kohlenstofffilz noch gepresst S200 werden, und dann auf die zweite Haspel 122 aufgewickelt S300 werden.

Der beschichtete Kohlenstofffilz kann schließlich beispielsweise als eine Gasdiffusionselektrode oder als Teil einer Gasdiffusionselektrode verwendet werden.

In der vorangegangenen detaillierten Beschreibung sind verschiedene Merkmale zur Verbesserung der Stringenz der Darstellung in einem oder mehreren Beispielen zusammengefasst worden. Es sollte dabei jedoch klar sein, dass die obige Beschreibung lediglich illustrativer, keinesfalls jedoch beschränkender Natur ist. Sie dient der Abdeckung aller Alternativen, Modifikationen und Äquivalente der verschiedenen Merkmale und Ausführungsbeispiele. Viele andere Beispiele werden dem Fachmann aufgrund seiner fachlichen Kenntnisse in Anbetracht der obigen Beschreibung sofort und unmittelbar klar sein.

Die Ausführungsbeispiele wurden ausgewählt und beschrieben, um die der Erfindung zugrundeliegenden Prinzipien und ihre Anwendungsmöglichkeiten in der Praxis bestmöglich darstellen zu können. Dadurch können Fachleute die Erfindung und ihre verschiedenen Ausführungsbeispiele in Bezug auf den beabsichtigten Einsatzzweck optimal modifizieren und nutzen.

Bezugszeichenliste

| | |
|---|---|
| 1 | zu beschichtendes Material |
| 2 | Beschichtungsmaterial |
| 3 | Vakuum |
| 51 | Beschichtungsbereich |
| 53 | Wärmebehandlungsbereich |
| 100 | Vorrichtung |
| 101 | Reinigungseinrichtung |
| 102 | Vorbehandlungseinrichtung |
| 103 | Wärmebehandlungseinrichtung |
| 104 | Presse |
| 105 | Elektrische-Polarisationswalze |
| 110 | Beschichtungskammer |
| 120 | Führungseinrichtung |
| 121 | erste Haspel |
| 122 | zweite Haspel |
| 130 | Beschichtungseinrichtung |
| 131 | Vakuumquelle |
| 132 | Verdampfer |
| 140 | Leiteinrichtungen |

| | |
|---|---|
| S01 | Abwickeln |
| S02 | chemisches Reinigen |
| S03 | Vorbehandlung |
| S10 | Fortlaufendes Führen |
| S20 | Fortlaufendes Beschichten |
| S100 | Wärmebehandlung |
| S200 | Pressen |
| S300 | Aufwickeln |

**Patentansprüche**

1. Verfahren zum mindestens teilweisen dreidimensionalen Beschichten eines porösen Materials, umfassend:
fortlaufendes Führen (S10) eines zu beschichtenden porösen Materials (1) durch eine Beschichtungskammer (110); und fortlaufendes Beschichten (S20) jeweils eines aktuell in der Beschichtungskammer (110) befindlichen Teils des zu beschichtenden porösen Materials (1) mittels physikalischer Gasphasenabscheidung in einem Vakuum (3) mit einem Beschichtungsmaterial (2), welches zumindest beim Beschichten strömungsmechanische Eigenschaften im Knudsen-Bereich aufweist.

2. Verfahren nach Patentanspruch 1,
wobei das poröse zu beschichtende Material (1) ein Gewebe, ein Gelege, ein Gewirke, ein Gestrick, ein Geflecht, ein Vlies, einen Filz, und/oder eine dauerhafte Schaumstruktur umfasst.

3. Verfahren nach Anspruch 2,
wobei das poröse zu beschichtende Material (1) einen Kohlenstofffilz oder einen Metallschaum aufweist oder daraus besteht.

4. Verfahren nach einem der Patentansprüche 1 bis 3, wobei das Beschichtungsmaterial (2) ein metallisches Material ist oder umfasst, insbesondere Kupfer, Nickel, Mangan oder Silber, oder eine Legierung mit mindestens einem dieser Metalle oder ein Material, dessen Hauptbestandteil eines dieser Metalle ist.

5. Verfahren nach einem der Patentansprüche 1 bis 4, wobei das Beschichtungsmaterial (2) Silizium ist oder umfasst.

6. Verfahren nach einem der Patentansprüche 1 bis 5, wobei das Beschichtungsmaterial (2) einen Dampfdruck beim jeweiligen Schmelzpunkt von $10^{-6}$ mbar bis 10 mbar aufweist.

7. Verfahren nach einem der Patentansprüche 1 bis 6, wobei das Beschichtungsmaterial (2) einen Schmelzpunkt von zwischen 300°C und 1500°C aufweist, insbesondere von zwischen 400°C und 1200°C.

8. Verfahren nach einem der Patentansprüche 1 bis 7, wobei das poröse zu beschichtende Material (1) eine Porenweite von 1 mm oder kleiner, und/oder eine spezifische Oberfläche nach dem BET-Verfahren von 0,1 $m^2g^{-1}$ oder größer aufweist.

9. Verfahren nach einem der Patentansprüche 1 bis 8, wobei das poröse zu beschichtende Material (1) eine Haspelware ist und insbesondere im Verlauf des Verfahrens vor dem fortlaufenden Beschichten (S20) von einer Haspel (121) abgewickelt und/oder nach dem fortlaufenden Beschichten (S20) auf eine Haspel (122) aufgewickelt wird.

10. Verfahren nach einem der Patentansprüche 1 bis 9, umfassend eine Wärmebehandlung (S100) des beschichteten Materials (1) außerhalb der Beschichtungskammer (110) nach dem Beschichten (S20).

11. Verfahren nach einem der Patentansprüche 1 bis 10, wobei das Führen (S10) und das Beschichten (S20) derart durchgeführt werden, dass das Beschichtungsmaterial (2) im Wesentlichen nur in bis zu 5 bis 45 % der Dicke des zu beschichtenden porösen Materials (1) eindringt.

12. Verfahren nach einem der Patentansprüche 1 bis 11, wobei das Beschichten (S20) einseitig oder beidseitig erfolgt.

13. Verfahren nach einem der Patentansprüche 1 bis 12, wobei das beschichtete poröse Material (1) nach Verlassen der Beschichtungskammer (110) zumindest teilweise gepresst (S200) wird, um dessen Dicke dauerhaft zu verringern und/oder dessen Dichte zu dauerhaft zu vergrößern.

14. Verfahren nach einem der Patentansprüche 1 bis 13, wobei das beschichtete poröse Material (1) als eine Gasdiffusionselektrode oder als Teil einer Gasdiffusionselektrode verwendet wird.

15. Vorrichtung (100) zum mindestens teilweisen 3-dimensionalen Beschichten eines porösen Materials (1), umfassend:

    eine Beschichtungskammer (110);
    eine Führungseinrichtung (120), welche dazu eingerichtet ist, ein poröses zu beschichtendes Materials (1) fortlaufend durch die Beschichtungskammer zu führen; und
    eine Beschichtungseinrichtung (130), welche dazu eingerichtet ist, jeweils einen aktuell in der Beschichtungskammer (110) befindlichen Teil des zu beschichtenden Materials (1) mittels physikalischer Gasphasenabscheidung in einem Vakuum (3) mit einem Beschichtungsmaterial (2) zu beschichten, welches zumindest beim Beschichten strömungsmechanische Eigenschaften im Knudsen-Bereich aufweist.

Fig. 1

Fig. 2

100

104  103  105    110  3    1    102  101    120

130

53    51

Fig. 3

S01

S02

S03

S10

S20

S100

S200

S300

Fig. 4

Europäisches
Patentamt

European
Patent Office

Office européen
des brevets

# EUROPÄISCHER RECHERCHENBERICHT

**Nummer der Anmeldung**

EP 24 18 3794

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | BISZTYGA-SZKLARZ MAGDALENA ET AL: "In Situ Regeneration of Copper-Coated Gas Diffusion Electrodes for Electroreduction of CO2 to Ethylene", MATER, Bd. 14, Nr. 12, 9. Juni 2021 (2021-06-09), Seite 3171, XP093261262, ISSN: 1996-1944, DOI: 10.3390/ma14123171 * 2. Materials and Methods * ----- | 2-4,6,7, 14 | INV. C23C14/04 C23C14/18 C23C14/32 C23C14/34 C23C14/56 |
| X | US 2007/248752 A1 (O'BRIEN DENNIS P [US] ET AL) 25. Oktober 2007 (2007-10-25) <br><br>* Absatz [0021] * <br>* Absatz [0028] * <br>* Absatz [0038] - Absatz [0042] * <br>* Absatz [0058] - Absatz [0062] * <br>* Abbildungen 1, 3a * ----- | 1-6, 8-12,14, 15 | |
| X | US 4 532 889 A (COFFY RENE L [FR]) 6. August 1985 (1985-08-06) * Spalte 5, Zeile 35 - Spalte 6, Zeile 43 * ----- | 1,2,7,15 | |
| | | | **RECHERCHIERTE SACHGEBIETE (IPC)** C23C |
| A | DE 10 2018 220678 A1 (THYSSENKRUPP AG [DE]; THYSSENKRUPP STEEL EUROPE AG [DE]) 4. Juni 2020 (2020-06-04) * Absatz [0005] * <br>* Absatz [0026] - Absatz [0029] * <br>* Abbildungen 1, 2 * ----- <br>-/-- | 1,15 | |

Der vorliegende Recherchenbericht wurde für alle Patentansprüche erstellt

| Recherchenort | Abschlußdatum der Recherche | Prüfer |
|---|---|---|
| Den Haag | 1. Mai 2025 | Fertig, Andrea |

EPO FORM 1503 03.82 (P04C03)

Seite 1 von 3

Europäisches
Patentamt

European
Patent Office

Office européen
des brevets

# EUROPÄISCHER RECHERCHENBERICHT

**Nummer der Anmeldung**

EP 24 18 3794

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | BOBZIN KIRSTEN ET AL: "Continuum and kinetic simulations of the neutral gas flow in an industrial physical vapor deposition reactor", SURFACE AND COATINGS TECHNOLOGY, Bd. 237, 19. August 2013 (2013-08-19), Seiten 176-181, XP093260802, NL ISSN: 0257-8972, DOI: 10.1016/j.surfcoat.2013.08.018 * Zusammenfassung * * 2. Setup * * 4. Results and discussion * ----- | 1,15 | |
| A | JIMENEZ FRANCISCO J. ET AL: "Comprehensive computer model for magnetron sputtering. I. Gas heating and rarefaction", JOURNAL OF VACUUM SCIENCE, Bd. 30, Nr. 4, 15. Mai 2012 (2012-05-15), XP093260801, 2 Huntington Quadrangle, Melville, NY 11747 ISSN: 0734-2101, DOI: 10.1116/1.4712534 Gefunden im Internet: URL:https://pubs.aip.org/avs/jva/article-pdf/doi/10.1116/1.4712534/14812962/041302_1_online.pdf> * Introduction * * III. THERMSPUD MODULE * * D. Gas rarefaction * ----- | 1,15 | **RECHERCHIERTE SACHGEBIETE (IPC)** |

-/--

Der vorliegende Recherchenbericht wurde für alle Patentansprüche erstellt

| Recherchenort | Abschlußdatum der Recherche | Prüfer |
|---|---|---|
| Den Haag | 1. Mai 2025 | Fertig, Andrea |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

**Nummer der Anmeldung**

EP 24 18 3794

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | MOISEEV K. M. ET AL: "Use of magnetron sputtering with liquid target in manufacturing of electronic components for spacecraft", XLIII ACADEMIC SPACE CONFERENCE: DEDICATED TO THE MEMORY OF ACADEMICIAN S.P. KOROLEV AND OTHER OUTSTANDING RUSSIAN SCIENTISTS - PIONEERS OF SPACE EXPLORATION, Bd. 2171, 15. November 2019 (2019-11-15), Seite 170010, XP093260903, DOI: 10.1063/1.5133321 * MATERIALS AND METHODS * * RESULTS * ----- | 4-7 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 1. Mai 2025 | Fertig, Andrea |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

Seite 3 von 3

Europäisches
Patentamt

European
Patent Office

Office européen
des brevets

**Nummer der Anmeldung**

EP 24 18 3794

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

    Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

    2-12, 14, 15(vollständig); 1(teilweise)

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

Nummer der Anmeldung

EP 24 18 3794

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 2-12, 14, 15(vollständig); 1(teilweise)

   Verfahren zum mindestens teilweisen dreidimensionalen Beschichten eines porösen Materials in Form eines Kohlenstofffilzes oder Metallschaums mit einer metallischen Beschichtung aus Kupfer, Nickel, Mangan, Silber oder Silizium

   ---

2. Ansprüche: 13(vollständig); 1(teilweise)

   Verfahren zum mindestens teilweisen dreidimensionalen Beschichten eines porösen Materials, wobei des beschichteten porösen Materials nach Verlassen der Beschichtungskammer gepresst wird

   ---

**ANHANG ZUM EUROPÄISCHEN RECHERCHENBERICHT
ÜBER DIE EUROPÄISCHE PATENTANMELDUNG NR.**

EP 24 18 3794

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-05-2025

| Im Recherchenbericht angeführtes Patentdokument | Datum der Veröffentlichung | Mitglied(er) der Patentfamilie | Datum der Veröffentlichung |
|---|---|---|---|
| US 2007248752 A1 | 25-10-2007 | CN 101427405 A | 06-05-2009 |
| | | EP 2011181 A2 | 07-01-2009 |
| | | JP 2009534177 A | 24-09-2009 |
| | | US 2007248752 A1 | 25-10-2007 |
| | | WO 2007140051 A2 | 06-12-2007 |
| US 4532889 A | 06-08-1985 | EP 0131513 A1 | 16-01-1985 |
| | | FR 2548589 A1 | 11-01-1985 |
| | | JP H0128824 B2 | 06-06-1989 |
| | | JP S6046337 A | 13-03-1985 |
| | | US 4532889 A | 06-08-1985 |
| DE 102018220678 A1 | 04-06-2020 | DE 102018220678 A1 | 04-06-2020 |
| | | EP 3660181 A1 | 03-06-2020 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2023152305 A1